# EUROPEAN PATENT APPLICATION

(11) **EP 4 068 393 A1**
(43) Date of publication of application: **05.10.2022**
(21) Application number: 21166278.8
(22) Date of filing: 31.03.2021
(51) Int. Cl.: H01L 31/0224, H01L 31/0747, H01L 31/18

(54) **METHOD FOR MANUFACTURING SOLAR CELLS AND SOLAR MODULE**

(71) Applicant: Meyer Burger Research AG, 2068 Hauterive (CH)
(72) Inventor: Papet, Pierre, 2068 Hauterive (CH); Legradic, Boris, 1400 Yverdon (CH); Strahm, Benjamin, 1429 Giez (CH); Bätzner, Derk, 3232 Ins (CH)
(74) Representative: Krujatz, Jörg Martin

(57) **Abstract**

The invention relates to a method for manufacturing solar cells with a solar cell base substrate and comprising at least one deposition step of depositing a electrically conductive coating on a front side of the solar cell substrate and/or on the back side of the solar cell substrate, wherein a tray with at least one substrate pocket is used to support the substrate within a deposition chamber for depositing the electrically conductive coating, wherein the conductive coating extends to edges at edge sides of the solar cell substrate in order to include an 1 mm wide corner region of the solar cell in an exploited area of the solar cell and wherein short circuits between the front side and the back side of the solar cell are avoided in the manufactured solar cell. An object of the invention is to suggest an improved manufacturing method that yields in efficient solar cells. This object is reached by a method for manufacturing solar cells, wherein the electrically conductive coating is deposited with a decreasing thickness in a 2 mm wide corner region of the base substrate thus that the thickness at the substrate edge and on the substrate edge side is sufficiently low in order to avoid short circuit loss at the substrate edge side, wherein the decreasing thickness is produced by projections at substrate pocket edges having a projection height that projects at least 300 µm over the substrate surface of the front side and/or the back side.

## Description

The invention relates to a method for manufacturing solar cells with a solar cell base substrate and comprising at least one deposition step of depositing an electrically conductive coating on a front side of the solar cell substrate and/or on the back side of the solar cell substrate, wherein a tray with at least one substrate pocket is used to support the substrate within a deposition chamber for depositing the electrically conductive coating, wherein the conductive coating extends to corners at edges of the solar cell substrate in order to include an 1 mm corner region of the solar cell in an exploited area of the solar cell and wherein a short circuit loss between the front side and the back side of the solar cell is avoided in the manufactured solar cell. The invention further relates to a solar module made of accordingly manufactured solar cells.

In the prior art manufacturing methods of solar cells are known that comprise different deposition steps of conductive layers on a base substrate. The base substrate has the functionality of the base forming a p-n junction in combination with an emitter layer in the manufactured solar cell device. The method may further contain steps of depositing insulating layers. Crystalline silicon wafers are the most frequently used base substrates in the solar industry.

The deposited conductive layers or films unfold their main functionality on a main surface of the base substrate, wherein the front side respectively the sunny side and the opposed back side are summarized as main surfaces. However, also structure, shape and sequence of films on the wafer edge surfaces may be important. Especially for conductive films the formation of short circuits has to be avoided e.g. by a proper film sequence or a structure with a gap in-between a conductive front side film and a conductive back side film. In a laboratory manufacturing method the coating from solar wafer edge surfaces may be removed by grinding or etching. For industrial production it is desirable to avoid those costly steps. EP 2 682 990 A1 describes a method of manufacturing heterojunction solar cells wherein a circumferential wafer support serves as a mask in order to produce solar cells with an about 1 mm broad circumferential corner region without a TCO deposition. This corner region ensures an insulation in-between the front side transparent conductive oxide (TCO) and a back side TCO. A drawback of this method and the relating solar cell structure is that the corner region of the substrate is not fully utilized for the generation of photo current in the later usage of the solar cell in a solar module.

It is therefore an object of the invention to suggest an improved manufacturing method that yields in efficient solar cells.

This object is reached by a method for manufacturing solar cells, wherein the electrically conductive coating is deposited with a decreasing thickness in a 2 mm wide corner region of the base substrate (decreasing in a direction from the substrate center to the substrate edge) thus that the thickness at the substrate corner and on the substrate edge is sufficiently low in order to avoid short circuit loss at the substrate edge, wherein the decreasing thickness is produced by projections at substrate pocket edges having a projection height that projects at least 300 µm over the substrate surface of the front side and/or of the back side.

In other words, the conductive coating is covering basically the whole substrate main surface (front side and/or back side) including the corner region. None edge exclusion is applied during the manufacturing of the conductive coating. Thus the whole substrate surface is coated and can accordingly contribute to the solar cells performance. Short circuits at the wafer edge are avoided by no or almost no deposition of the conductive coating on the wafer edges but ending at the corner of the main surface or near that corner. A side effect of the deposition just to the corner is a decreasing thickness of the conductive film near the circumferential corner line in the corner region of the main surface. The thickness reduction in the direction toward the substrate corner ranges over a maximum 2 mm wide corner region (or edge stripe) surrounding the solar wafers main surface where the thickness is below 90 % of the average film thickness of the conductive coating. The width of the corner region is technologically minimized, preferably below 1 mm. The deposition (with decreasing thickness) to the corner of the coated surface is reached by using substrate pockets projecting over the substrate (main) surface. This projection effects the angular distribution of deposition particles. The deposition particles can be e.g. atoms, molecules or radicals in different processes. In the angular distribution can be distinguished between normal incidence (90°) on the substrate (main) surface, incidence angles < 90° allowing deposition particles to arrive the substrate from source positions lateral beside the subtrate to arrive the substrate and incidence angles > 90°. Particles with incidence angles < 90° are partially cut off by the protrusion. Thus the protrusion at the substrate pocket edge effects a partial shading hindering on the one hand a deposition of the conductive coating on the wafer edge and causing on the other hand also the non-uniformity with the decreasing thickness on the main substrate surface near the substrate corner. Thus the decreasing thickness of the conductive film indicates this used deposition technique with projecting substrate pockets.

A deposition step of depositing at least one conductive coating can comprise the deposition of a n-doped silicon layer on a n-doped silicon wafer as base substrate with a decreasing thickness at the wafer corner. For the production of different types of solar cells different wafers and films are used. At the filing date of this document p-type Si-wafers have the major market share, while n-type wafers have a minor market share. But the n-type Si-wafers are used for the production of high efficiency solar cells. The high efficiency solar cells may be heterojunction solar cells that have a n-doped Si-film on one main surface, wherein this Si film has the decreasing thickness at the wafer edge as described above. The non-conformal thickness of the n-doped silicon layer in the corner region contributes to maximized solar cell efficiencies and furthermore to avoided short circuit losses to the p-doped emitter that is made then on the other surface of the solar wafer.

The lateral pocket of the substrate carrier can have dimensions being 0.5 mm larger then lateral substrate dimensions and the projection height can be 0.8 mm or larger. Deposition characteristics, conformity and shading are influenced by several geometric and other physical parameters. An expert in the field of the invention knows relevant process parameters in his deposition process that are needed for the definition of the pocket dimension for realizing the on hand invention for a special deposition step. Those relevant process parameters are amongst others the angular distribution of deposition particles (further depending from the used deposition parameters), statistics of variations of wafer dimensions, mechanical limitations in wafer transportation means in the used deposition tool etc.. In other embodiments other dimensions, e.g. higher projections may be used.

In the invented method can be comprised a sub step of depositing a TCO layer with a decreasing thickness at the wafer edge on top of a n-doped silicon coating and/or on top of a p-doped silicon layer wherein the n-doped silicon layer defines a n-side of the solar cell and the p-doped silicon layer defines a p-side of the solar cell. The arrangement of TCO layers on top of doped semiconductor layers is typical for heterojunction (HJT) solar cells. The front side (sunny side) of the solar cell has a n-doped silicon coating in some embodiments and a p-doped silicon coating in other embodiments. The backside has then respectively the invers (p- or n-) doped coating. Short-circuits at the wafer edge are avoided by depositing the TCO layer(s) just on the full front side and/or the back side but not on the edge of the solar cell. For solar cells with high efficiencies and in bifacial applications the doping type may be a more suitable property to distinguish in-between the one side and the other then the wording "front side" and "back side" since the visual differences vanish with an increasing degree of bifaciality.

The substrate pocket of the tray can have an open bottom with exemption of small area substrate supports and the deposition step of the TCO layer can comprise both a TCO deposition on the n-side of the solar cell and a TCO deposition on the p-side, wherein the protrusion height on the n-side is 0.3 mm or larger and the protrusion height on the p-side is larger than on the n-side. In this embodiment a two side-TCO deposition is enabled by using a tray that has substrate pockets with bottom openings in order to allow a deposition on both sides, the solar cells n-side and the solar cells p-side, without exchanging the tray in-between both deposition sub-steps.

Since the solar wafer lies on small area supports, only the upper side is fully open. The bottom side is almost fully open with exemption of the technically required small area substrate supports. Different protrusion heights on the n-side and the p-side effect different film thickness uniformities at the wafer edge. A lower protrusion height effects a higher uniformity on the substrate and a less pronounced thickness decrease on the wafers main surface at the corners and a higher probability that a thin deposition occurs around the corner on the edge of the substrate. The higher the protrusion height, the lower is the deposition on the edge (down to zero) and the higher is the thickness reduction on the main surface near the corner. With different protrusion heights, the deposition of the different films on the substrates edge can be separately controlled and optimized as required. In the example that the protrusion height on the n-side is 300 µm large while the protrusion height on the p-side is even larger then on the n-side, a deposition on the wafer edge on the p-side is further reduced then on the n-side. Short circuits, respectively low resistivity shunt resistances, are avoided even though both main surfaces are fully coated and accordingly fully utilized for the solar cells functionality.

The above described deposition steps for depositing conductive Si layers and TCO layers can be executed in the following order:
1. on the front side of the n doped base wafer the n-doped Si layer is deposited;
2. on the back side a p-doped Si layer is deposited with a better conformity then the front side n-doped Si
3. on the front side and the back side TCO layers are deposited, each with a decreasing thickness at the wafer edges.
Thus four conductive films, two Si films and two TCO films are deposited according to the invention with a decreasing thickness next to the circumferential corners of the main surfaces of the solar base wafer. Each of the four single deposition conditions can be optimized for the best solar cells characteristics. Exemplary, the coating structure at the wafer edge is optimized such that a nonlinear shunt resistance is formed, wherein the shunt resistance drops fast with increasing negative voltage applied on the solar cell. At positive solar cell voltage (in regular operating modes where light energy is converted in electrical energy) the shunt resistance is high and the current loss in the shunt is accordingly negligible. However, at high negative voltage the shunt resistance becomes low. A negative voltage occurs when the solar cell is part of a solar module with solar cells in the series circuit; and the solar cell is shaded while other solar cells in the series are illuminated. Thus the heat that is generated in this solar cell is distributed by the wafer edge shunt along the wafer edge on the whole solar wafer. By the better heat distribution, the thermal stress for the solar cell is thereby reduced in such hot spot situations. The nonlinear shunt resistance can be considered as a separate electrical device contributing to improved properties of the manufactured solar cell and of solar modules using such solar cells.

The projection of the substrate support tray can be formed by a mask with mask edges being laterally aligned to substrate edges or the mask being laterally overlapped the wafer edge with an overlap of 1 mm or less, wherein a vertical gap between the mask and the substrate enables a non-uniform deposition in the masked corner region onto the substrate. The mask gives sophisticated possibilities in forming the protrusion since the mask can be positioned on the tray after the tray is loaded with substrates. Therefore the width of the substrate pocket can be defined smaller than the substrate width.

A solar module made of solar cells that are manufactured with the invented method is also an aspect of the invention. The above described options and embodiments of the manufacturing method result in respective structures of the manufactured solar cells and solar modules.

In the following, the on hand invention shall be explained by means of figures which show:
- Fig. 1: an edge part of a solar cell with decreasing thickness of a conductive film,
- Fig. 2a: a part of a substrate carrier with a substrate in a substrate pocket,
- Fig. 2b: different incident angle types in angular distribution of deposition particles,
- Fig. 3: an edge part of a solar cell with four conductive films with decreasing thickness,
- Fig. 4a: a part of a tray having substrate pockets with open bottom and
- Fig. 4b: top view on the part of the tray with a substrate in the substrate pocket.

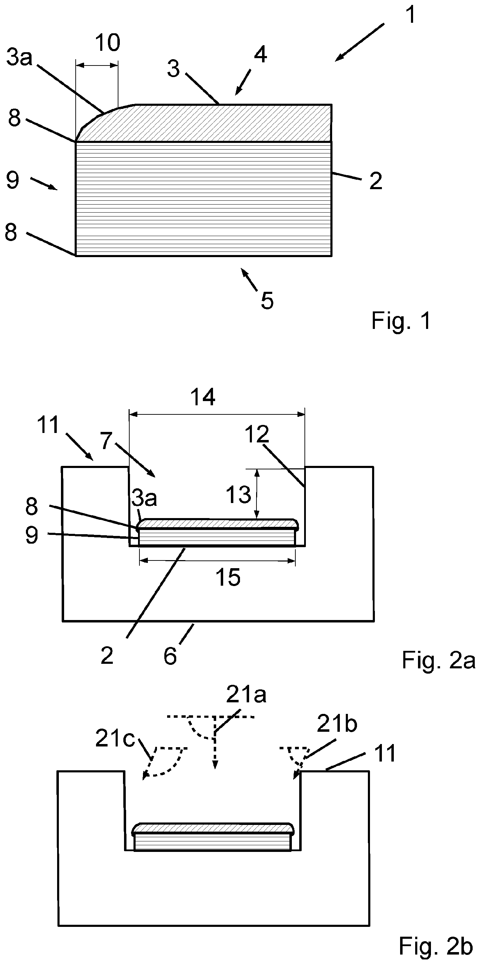

Figure Fig. 1 sketches an edge section of a solar cell 1 during the manufacturing of the solar cell 1 by a method that includes inter alia the steps of providing a solar wafer as a base substrate 2 and depositing a conductive coating 3 on a main surface 4, 5 of the base substrate 2. In the sketch of figure 1 just one main surface namely the front side 4 of the substrate 2 has a conductive coating 3. In real solar cells both main surfaces, the front side 4 and the back side 5, may have at least one conductive coating 3 according to the invention. In the simple sketch the decreasing thickness 3a of the conductive coating 3 near the main surface corners 8 at edge sides 9 of the substrate is visible. The conductive film 3 covers the whole front side surface 4 of the substrate 2 but does not extent conformally around the corner 8 on the edge 9 of the substrate 2. The decreasing thickness 3a in an corner region 10 of the main surface is a side effect of the used deposition equipment and method for depositing the conductive coating 3 just to the corner 8 but not around the corner 8 on the edge 9.

Reference signs are identic in all figures for same or similar objects. Thereby the repetition of descriptions is widely avoided.

The sketch in figure 2a helps to explain the manufacturing step of the conductive coating 3 with the decreasing thickness 3a at the substrate edge 9. During the deposition of the coating 3 the substrate 2 lies in a substrate pocket 7 of a tray 6. The tray has usually several (e.g. 7 x 7 = 49) substrate pockets 7. For clarity just one pocket 7 is sketched. The tray 6 has projections 11 having a projection height 13 over the main surface (4, 5) to be coated. The lateral pocket dimension 14 is slightly larger than the lateral substrate dimension 15. The edge gap cannot be zero since the minimum pocket dimension depends on parameters like e.g. the statistical variations of substrate dimensions 15, the accuracy of the automatic transportation system etc..

In Fig. 2b different incident angle types in the angular distribution of deposition particle's trajectories are sketched at the same substrate pocket. The angular distribution contains normal incident particles arriving at the substrate surface in a normal direction 21a, particles with an incident angle direction < 90° 21b that arrive the substrate also from source points beside the main surface and particles with an incident angle direction > 90° 21c arriving the substrate only from center source points. The deposition particles 21b with the small incident angle are partially hindered by the protrusion 11 to arrive at the substrate. Thus a deposition on the wafer edge 9 is reduced or fully avoided and the film thickness is non-uniformly reduced within the corner region 10 of the deposited main surface 4, 5 of the substrate 2.

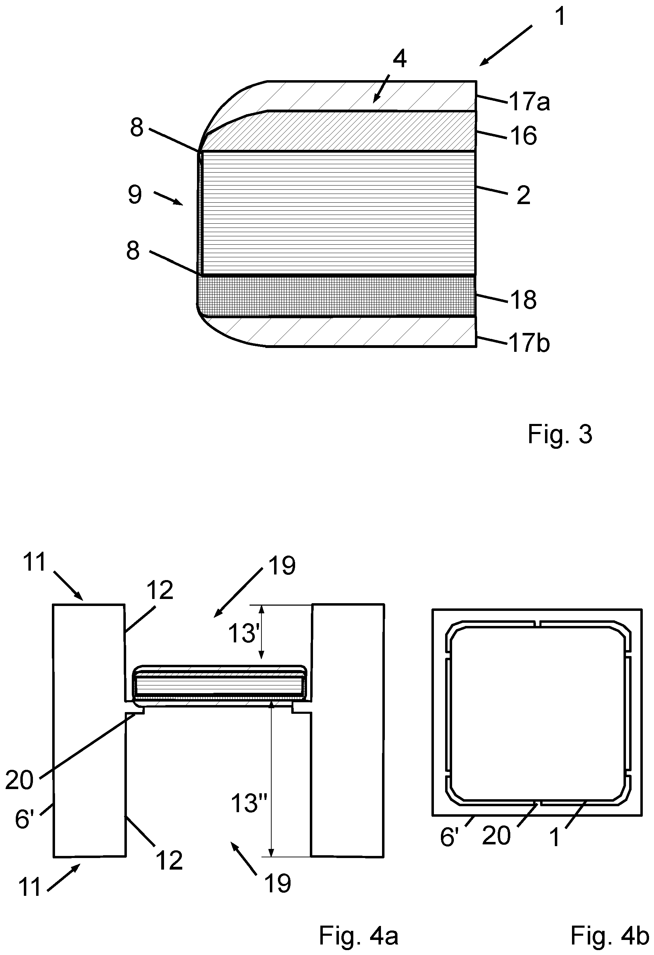

Fig. 3 shows a simplified cross section of a HJT solar cell near its edge 9. In this embodiment the base substrate 2 is a n-doped crystalline silicon wafer having a n-doped silicon layer 16 on its front side 4 and a p-doped silicon layer 18 on its backside 5 forming the emitter of the solar cell 1. The p-doped Si-layer 18 is deposited with a smaller protrusion height of the used tray 6 in the according deposition step then the n-doped layer 16. Therefore the conformity of the p-doped Si-Layer 18 is larger than the n-doped Si-Layer 16 as shown in Fig. 3. Also the conductive TCO layers 17a, 17b are deposited only on the main surfaces 4, 5 with a decreasing film thickness near the main surface corners 8. The edge 9 is in principle not coated by a TCO layer 17a, 17b. Thus short circuits and inacceptable shunt resistances in-between conductive layers 16, 17a, 18, 17b at the substrate edge 9 are avoided.

Fig. 4a shows a wafer tray having substrate pockets with open bottoms 19 used in a process for the deposition of TCO layers 17a and 17b. On those trays 6' substrates 2 can be coated on both sides 4, 5. Thus, a transfer from one tray to another tray in-between both deposition steps is avoided. Small substrate supports 20 are bearing the substrate in this tray 6' having the open bottom pockets 19. The supports 20 effect tolerable small not coated areas on the substrate. The projection height 13" at the substrates back side is larger than the projection height 13' at the substrates front side 4 in the drawn embodiment in cases where the emitter is deposited on the back side 5 of the solar cell. These geometrical parameters are optimized for optimum film thickness properties on the wafer edge 9 and in the corner region 10.

Fig. 4b is a top view on the tray of Fig. 4a clarifying the positions of the substrate supports 20. This figure also indicates that the shape of substrate pockets 7, 19 for pseudo quadratic substrates 2 has to have a similar pseudo quadratic shape.

### Reference signs

- 1: solar cell
- 2: base substrate
- 3: electrically conductive coating
- 3a: decreasing thickness of the electrically conductive coating
- 4: front side
- 5: back side
- 6,6': tray
- 7: substrate pocket
- 8: substrate corner of main surface
- 9: substrate edge
- 10: corner region
- 11: projection
- 12: substrate pocket edge
- 13, 13', 13": projection height
- 14: lateral pocket dimension
- 15: lateral substrate dimension
- 16: n-doped silicon layer
- 17a, 17b: TCO layers
- 18: p-doped silicon layer
- 19: substrate pocket with open bottom
- 20: substrate support
- 21a: normal incidence direction of deposition particles
- 21b: incidence direction with angle < 90° of deposition particles
- 21c: incidence direction with angle > 90° of deposition particles

## Claims

1. Method for manufacturing solar cells (1) with a solar cell base substrate (2) and comprising at least one deposition step of depositing an electrically conductive coating (3) on a front side (4) of the solar cell substrate (2) and/or on a back side (5) of the solar cell substrate (2), wherein a tray (6) with at least one substrate pocket (7) is used to support the substrate (2) within a deposition chamber for depositing the electrically conductive coating (3), wherein the conductive coating (3) extends to corners (8) at edges (9) of the solar cell substrate (2) in order to include an 1 mm wide corner region (10) of the solar cell (1) in an exploited area of the solar cell (1) and wherein a short circuit loss between the front side (4) and the back side (5) of the solar cell (1) is avoided in the manufactured solar cell (1),
**characterized in that**
the electrically conductive coating (3) is deposited with a decreasing thickness (3a) in a 2 mm wide corner region (10) of the base substrate (2) in a direction from the substrate center to the substrate corner (8) thus that the thickness in the corner region (10) is sufficiently low in order to avoid the short circuit loss, wherein the decreasing thickness (3a) is produced by projections (11) at substrate pocket edges (12) having a projection height (13) that projects at least 300 µm over the substrate surface of the front side (4) and/or of the back side (5).

2. Method according to claim 1, **characterized in that**
the deposition step comprises the deposition of a n-doped silicon layer (16) on a n-doped silicon wafer as base substrate (2) with a decreasing thickness (3) at the wafer edge (9).

3. Method according to claim 1 or 2, **characterized in hat**
lateral pocket dimensions (14) are 0.5 mm larger then lateral substrate dimensions (15) and that the projection height (13) is 0.8 mm or larger.

4. Method according to claim 1, 2 or 3 **characterized in that**
the deposition step comprises the deposition of a TCO layer (17a) with a decreasing thickness (3) at the wafer edge (9) on top of a n-doped silicon coating (16) and/or a TCO layer (17b) with a decreasing thickness (3) on top of a p-doped silicon layer (18) wherein the n-doped silicon layer (16) defines a n-side of the solar cell (1) and the p-doped silicon layer (18) defines a p-side of the solar cell (1).

5. Method according to claim 4, **characterized in that**
the tray (6') has a substrate pocket with an open bottom (19) with exemption of small area substrate supports (20) and the deposition step of the TCO layer (17) comprises both a TCO deposition on the n-side of the solar cell (1) and a TCO deposition on the p-side, wherein the protrusion height (13') on the n-side is 0.3 mm or larger and the protrusion height (13") on the p-side is larger then on the n-side.

6. Method according to claim 2 and claim 4, wherein the following method steps are executed in the given order:
- on the front side the n-doped Si layer (16) is deposited
- on the back side a p-doped Si layer (18) is deposited with a better conformity then the front side n-doped Si (16)
- on the front side (4) and the back side (5) TCO layers (17) are deposited, each with a decreasing thickness (3) at the wafer corners (8).

7. Method according to claim 6, wherein the coating structure at the wafer edge (9) is optimized such that a nonlinear shunt resistance is formed, wherein the shunt resistance drops fast with increasing negative voltage applied on the solar cell (1).

8. Method according to claim 1, **characterized in that**
the protrusion (11) is formed by a mask with mask edges being laterally aligned to substrate edges (9) or the mask being laterally overlapped the wafer edge (9) with an overlap of 1 mm or less, wherein a vertical gap between the mask and the substrate (2) enables a non-uniformly deposition in the masked corner region (10) onto the substrate.

9. Solar module made of solar cells (1) manufactured with a method according to at least one of the claims 1-8.
